# EUROPEAN PATENT SPECIFICATION

(11) **EP 3 327 885 B1**
(45) Date of publication and mention of the grant of the patent: **25.10.2023**
(21) Application number: 17202967.0
(22) Date of filing: 22.11.2017
(51) Int. Cl.: H02H 1/00, H02H 3/00, G01R 31/52

(54) **ARC FAULT INTERRUPTER DEVICE, ARC FAULT DETECTION METHOD IN A CIRCUIT INTERRUPTER DEVICE AND COMPUTER PROGRAM PRODUCT**
STÖRLICHTBOGEN-UNTERBRECHUNGSVORRICHTUNG, VERFAHREN ZUR ERKENNUNG VON STÖRLICHTBOGEN IN EINER SCHALTKREIS-UNTERBRECHUNGSVORRICHTUNG UND COMPUTERPROGRAMMPRODUKT
DISPOSITIF D'INTERRUPTION POUR DÉFAUT D'ARC, PROCÉDÉ DE DÉTECTION DE DÉFAUT D'ARC DANS UN DISPOSITIF D'INTERRUPTION DE CIRCUIT ET PROGRAMME INFORMATIQUE

(30) Priority: 23.11.2016 US 201615360007
(43) Date of publication of application: 30.05.2018
(73) Proprietor: Schneider Electric USA, Inc., Boston, MA 02108 (US)
(72) Inventor: JAKUPI, ANDI, Marion, IA 52302 (US)
(74) Representative: Murgitroyd & Company

(56) References cited:
- US-A1- 2007 055 889
- US-A1- 2008 204 947
- US-B1- 6 456 471

## Description

### FIELD of the INVENTION

The invention relates to the field of arc fault detection, and more particularly, to an approach for improving immunity against nuisance tripping in arc fault circuit interruption devices.

### BACKGROUND

An arc fault circuit interrupter has an arc detection device used to detect hazardous arcing events on a circuit, and in response, to trip a circuit interrupter and remove power to the circuit. These arc fault devices may include circuit breakers such as Combination Arc Fault Circuit Interrupters (for parallel and series arcs) and include Dual Function (Arc Fault (AF) and Ground Fault (GF)) circuit interrupters of the Combination type. Other arc fault circuit interrupter devices other than circuit breakers might be placed at outlet receptacles or the like.

Arc fault detection is a probability determination. Sometimes the arc detection algorithm implementation may have a hard time providing a clean distinction between the current "signature" of some loads and a real arc fault event and thus the detection algorithm errors on the arc fault side and causes nuisance trips. Thus, an arc fault detection device may be subject to unwanted tripping, such as nuisance tripping or false positive tripping, which is an inconvenience to the user, or worse. Over the past decade, improvements have been made to detection algorithms used in arc fault detection devices in order to increase immunity against unwanted tripping. The detection algorithm for a known breaker is paired in a single program with the multiple parameters stored as pre-computed look-up-table (LUT) values, necessary for determining the "signature" of an arc event. A complex arc event signature is defined by more parameters, which makes it easier to distinguish between different types of tripping events. Thus, more signatures will yield more and better discrimination of nuisance trip signatures versus real arcing event tripping. However, there are practical limits on the speed and expense of computing power for the detection algorithm, and the space available for same, for determining a broad range of arcing event signatures, especially within a miniature circuit breaker (MCB).

Known arc fault breakers are generally supplied with a "one size fits all" combination algorithm/LUT. This default algorithm and LUT may cover most of the load combinations in a house, and e.g. work well in the kitchen with various kitchen specific loads and/or bedroom loads, but it might not be as robust with bathroom loads or living room loads. Meanwhile another algorithm/LUT might have a better set of detection parameters that perform extremely well with bathroom and living room loads but not be loaded in the arc fault breaker.

Given that an arc fault detection device is expected to perform for a wide range of branch circuit loads not all of which can be accommodated by a single algorithm/LUT, and the arc fault breaker may have an installed lifetime of decades, thus encountering unforeseeable loads and load combinations over its life span, nuisance tripping may occur with unwanted frequency.

Further, it will be apparent from this discussion that due to the nature of arc fault expression and the complexity and variety of the loads which may be installed in e.g. a home, it is difficult to prevent nuisance tripping completely. At the same time it is very difficult to implement a nuisance prevention scheme covering all the possible combination loads a home might have. Document US 2008/0204947 is directed to a circuit interrupter whose settings are user-configurable via activation of a test button. Document US 6,456,471 is directed to an arc fault interrupter that analyzes startup current waveforms using algorithms that rely on counters and other variables. Document US 8,243,411 is directed to a circuit breaker that is capable of indicating a type of trip condition by automatically tripping as a function of the time elapsed after a user has held the push-to-test button.

### SUMMARY

The invention is defined by the independent apparatus and method claims and the embodiment by the dependent claims.

Aspects of the present invention can improve arc fault circuit breaker capability in a miniature circuit breaker (MCB) or other arc fault protection device and reduce nuisance tripping in an arc fault breaker, by separating the detection algorithm from the values in the pre-computed look-up-table (LUT) used with the algorithm. The precomputed LUT values are arranged in different LUTs to specifically address more particular groups of loads. Then, multiple LUT tables can be stored within the breaker and utilized with their characteristic load profiles and the detection algorithm to increase the scope of arc fault detection and be selected to decrease the amount of nuisance tripping. In one aspect of the invention, the user of the arc fault breaker can perform an LUT change for the arc fault breaker manually if the user notices the present configuration of arc detection is causing excessive nuisance tripping.

The present disclosure provides an arc fault detection device and method, which utilizes multiple LUTs which are switchable for use within the arc fault breaker. It will be noted that, due to cost prohibitions on available memory and processing power, the breaker can typically only run the algorithm with one set of parameters (LUT) at a time. If excess nuisance tripping is determined, a notice can be given to the operator and a change of LUTs can be initiated. For example, an adaptive arc fault detection device and method, such as described in Assignee's co-owned US patent application publication no. 2016/0149389, (also WO 2014/209311) entitled Adaptive Arc Fault Detection Trip Decision Buffer, to Jeremy D. Schroeder, may determine whether a detected arc fault tripping event is an unwanted tripping event and may be used to indicate it is time to initiate the change of LUTs within the arc fault breaker in accordance with the present invention. The user of the breaker may then choose a more selective LUT carried within the breaker to work with the detection algorithm and reduce the frequency of nuisance tripping.

### BRIEF DESCRIPTION OF THE DRAWINGS

The description of the various exemplary embodiments is explained in conjunction with the appended drawings, in which:
Fig. 1 illustrates a block diagram of some exemplary components of a circuit protective device, and especially a miniature circuit breaker, suitable for use with aspects of the present invention;
Fig. 2 illustrates a block diagram of an exemplary memory architecture in accordance with aspects of the present invention;
Fig. 3 illustrates a flow chart for firmware operation in accordance with aspects of the present invention;
Fig. 4 is a flow chart for LUT selection in accordance with aspects of the present invention.

### DETAILED DESCRIPTION

As an initial matter, it will be appreciated that the development of an actual commercial application incorporating aspects of the disclosed embodiments will require many implementation specific decisions to achieve the developer's ultimate goal for the commercial embodiment. Such implementation specific decisions may include, and likely are not limited to, compliance with system related, business related, government related and other constraints, which may vary by specific implementation, location and from time to time. While a developer's efforts might be complex and time consuming in an absolute sense, such efforts would nevertheless be a routine undertaking for those of skill in this art having the benefit of this disclosure.

It should also be understood that the embodiments disclosed and taught herein are susceptible to numerous and various modifications and alternative forms.

Further, words of degree, such as "about," "substantially," and the like may be used herein in the sense of "at, or nearly at, when given the manufacturing, design, and material tolerances inherent in the stated circumstances" and are used to prevent the unscrupulous infringer from unfairly taking advantage of the invention disclosure where exact or absolute figures and operational or structural relationships are stated as an aid to understanding the invention.

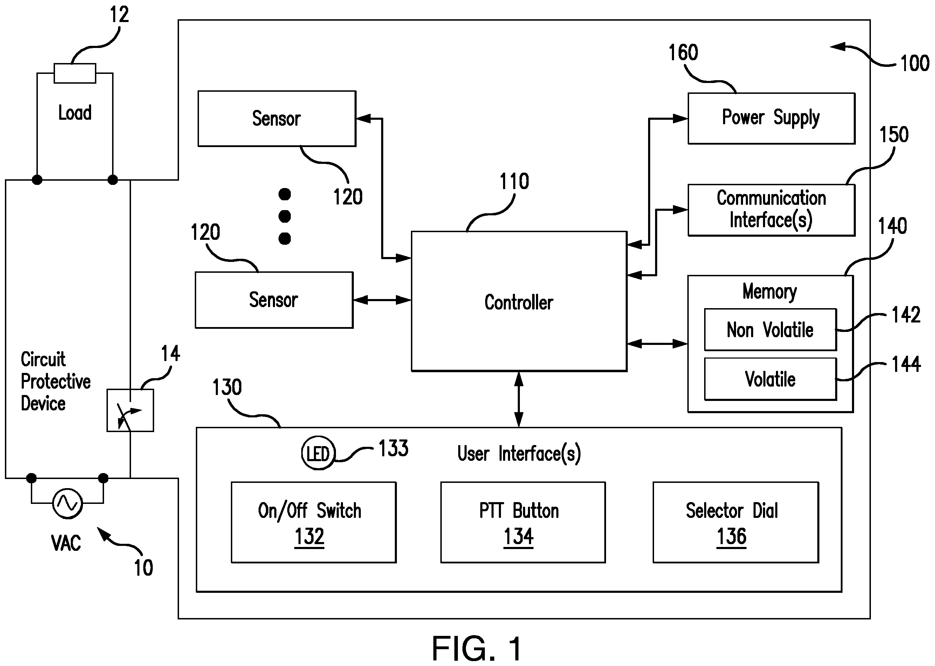

Fig. 1 illustrates a block diagram of some exemplary components of a circuit protective device, exemplified herein as a Dual Function/Combined Arc Fault Interrupter (DF/CAFI) arc fault Circuit Breaker device 100, as an aid to understanding aspects of the invention. As shown in Fig. 1, the breaker 100 may include a controller 110, sensors 120, user interfaces 130, a memory 140, a communication interface 150, a power supply 160, along with the separable contacts 114 for opening the circuit.

The sensors 120 may monitor or sense activities of the circuit breaker 100 such as when it is placed in an ON position and in a TRIPPED position. Sensors 120 can further include a voltage sensor or a current sensor, which can be used to sense electrical characteristics, such as a voltage or current, through the circuit 10 or a load 12 connected to the circuit 10. It will be understood that the sensors 120 may also include, or be connected to, signal conditioning circuits, threshold detectors, filters and analog-to digital converters for processing the sensed data prior to output to the controller 110.

The user interface(s) 130 may include a plurality of user input devices through which a user can input information or commands to the circuit breaker 100. The user interfaces 130 can include the already present On/Off switch 132 and Push To Test (PTT) button 134 as known in the art; and if desired, a Selector dial or switch 136 may be added for directly selecting the desired LUT. The user interface(s) 130 can include one or more light emitting diodes (LEDs) 133 as well. The communication interface(s) 150 can include communication circuitry for conducting line-based communications with an external device such as a UART, SPI, I2C, CAN, USB or Ethernet cable interface, or for conducting wireless communications with an external device through a wireless personal area network, a wireless local area network, a cellular network or wireless wide area network. The communication interface(s) 150 can be used to receive updates to the LUT database, which is made simpler through the separation of the detection algorithm from the LUTs, thus allowing specific memory address blocks to each LUT.

The memory 140 includes nonvolatile memory 142 and volatile memory 144 and can store a variety of computer executable code or programs, including the algorithm and the LUT selections, which when executed by the controller 110, controls the operations of the circuit breaker 100 as further explained below.

The controller 110 is in communication with the memory 140. The controller 110 is a processing system, such as a microcontroller or microprocessor or a state machine, which controls the operations of the circuit breaker 100, including the circuit breaker operation as described herein in the present disclosure. For example, the controller 110 can be configured to monitor through one or more of the sensors 120 a trip sequence implemented by the circuit breaker 100 as a function of time during a read out operation to indicate the selection of a particular LUT, as well as identifying a type of diagnostic condition as described in Assignee's co-owned US patent 8,243,411 to Brett Larson, entitled Electronic Miniature Circuit Breaker With Trip Indication Using The Breaker Tripping Function As The Feedback Mechanism, such as a type of fault condition from a prior occurrence of a trip event, or other diagnostic information through one or more of the user interfaces 130.

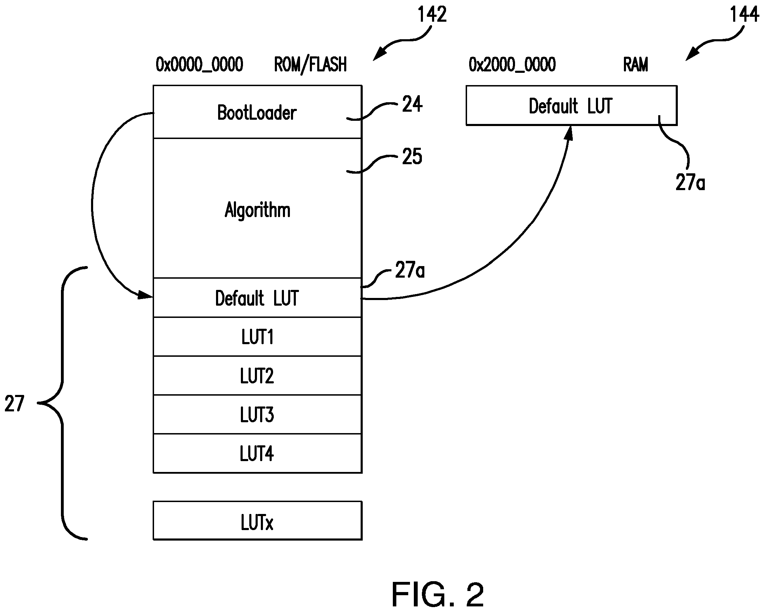

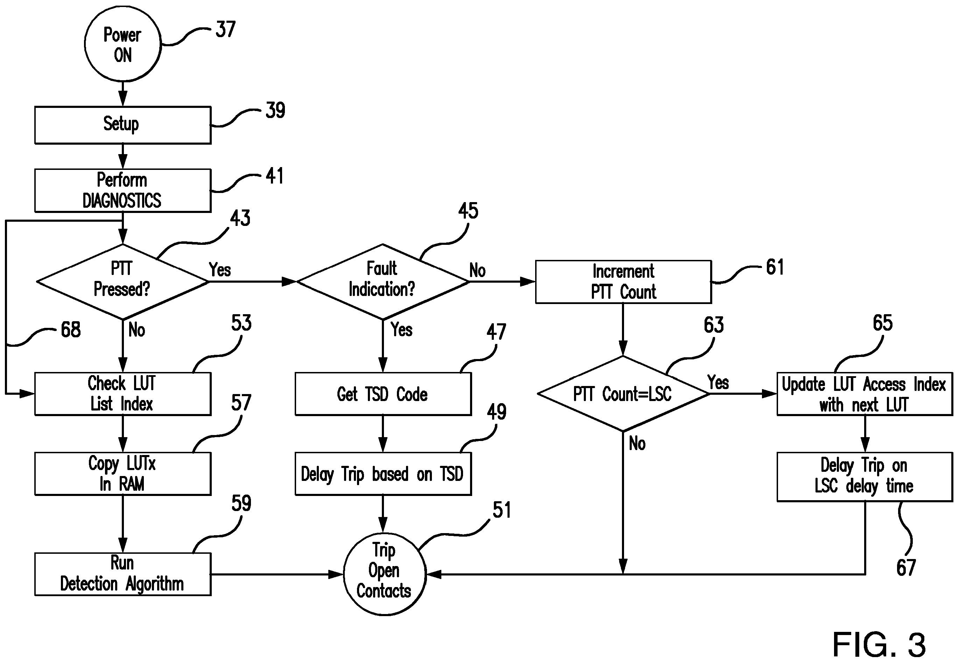

Fig. 2 diagrams the arc fault breaker volatile memory 144 and nonvolatile memory 142 contents including a bootloader 24, an arc detection algorithm 25, and a plurality of LUTs, collectively 27, which includes the default LUT 27a used for arc detection operations. It will be appreciated here that the nonvolatile, e.g. flash/ROM, memory 142 has separated the detection algorithm from the parameters/values it will use which are contained in the list of customized-load LUT tables; and that the LUTs 27 are stored in known memory locations for the detection algorithm 25 to utilize. Referring also to Fig. 3, upon power up, the bootloader 24 runs a routine to load the default LUT 27a into the volatile memory 21, e.g. RAM, for speed of processing, and continues normal protection operations running the detection algorithm 25 utilizing this LUT. Any of the various LUTs 27 can be selected as the initial/default LUT by operation of selectors at the breaker.

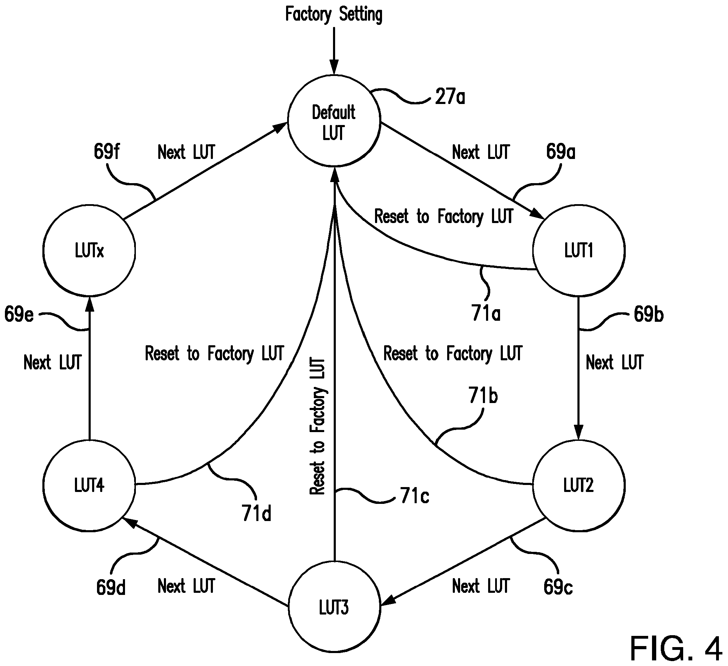

Referring also to Figs. 3 and 4, the default LUT selection 27a is set at manufacturing, but it can be switched to one of the other LUTs 27 via operation of the Push-To-Test (PTT) switch 31 and On/Off switch 33 combination, which are typically already in place on an arc fault MCB 100. Alternatively, if space is available, a dedicated push button (not shown) or a mechanical dial switch, or both, might be added to facilitate LUT selection. To indicate which LUT is selected, a Trip Indication with a delay as discussed in the aforementioned US patent 8,243,411, or the LED indicator 133 blinking a certain pattern, could offer this information to the user.

A suggested firmware operation for managing operation of the detection algorithm 25 to trip the breaker 100 and selection of the default LUT 27a is described in the flow chart of Fig. 3. While described in the context of firmware components, it will be realized that other forms of software can be utilized within the scope of the invention. At step 37 the circuit breaker 100 is switched on. The bootloader routine 24 is activated at step 39. Necessary diagnostics are then run at step 41. During diagnostics the PTT button status is checked at step 43 to see if it is pressed. If "Yes" a fault indication status is checked for at step 45. If a fault indication is present, the routine fetches the "time saver diagnostic" (TSD) code, which is a timed trip delay according to aforementioned US patent 8,243,411, at step 47, and a trip command is issued and held at step 49 until tripping (i.e. opening of the contacts) is accomplished to indicate the time delay at step 51. If the check at step 43 indicates the PTT button has not been pressed (i.e. a "NO"), the controller 110 will continue to check the LUT list index at step 53 to determine the identity of the default LUT 27a and copy it into RAM at step 57 for use in running the detection algorithm at step 59 for operation of the circuit interrupter, i.e. opening the contacts, at step 51.

If there is no fault indication at step 45 the PTT count is incremented at step 61. The PTT count is checked at step 63, and if PTT count equals the appropriate level (e.g. above a certain number of PTT button presses) it is recognized as an LUT Switch Count (LSC) and activates the LUT access index at step 65 and selects a new default LUT corresponding to the LSC. A time delay identifying the new LUT is entered at step 67 for tripping the contacts at a predetermined time delay to identify the selected LUT. The identification of the selected LUT can also be done with an indication from the LED 133 as explained above. It needs to be noted that while the breaker is checking the PTT state (pressed or not pressed) at step 43, it continues its protective function with the detection algorithm using the current LUT at step 53 as indicated by line 68. This state will continue unless and until a update/reset is issued at step 65 with the new LUT being selected.

Referencing Fig. 4, a basic outline of LUT selection is set forth. Other methods and means of switching between LUTs can be achieved, e.g. using a dial switch. From the user's point of view, each LUT can be dedicated to a particular load configuration/room, for example kitchen, bedroom, bathroom, garage, living room, etc. Thus the selectable LUTs might be designated by common household room locations and identified as one of "Kitchen Configuration," "Living Room Configuration," etc. to make selection intuitive for the user/installer. Each LUT can, for example, be UL Certified in the lab and verified under the standard testing procedures. As seen in Fig. 4, the user can switch, at steps 69a, 69b, 69c, 69d, 69e, 69f, between LUTs in a sequence order and if the entire limit/list of LUTs is consumed it will arrive back to the default LUT 27a. Alternatively, with a certain number and/or combination of PTT/On-Off switch presses/selections, the controller 110 can jump directly to the default LUT 27a at steps 71a, 71b, 71c, 71d, as shown in the diagram.

**.** The suggested firmware design separating the detection algorithm from the targeted parameters of multiple LUTs thus enables the load-specific configurations of LUTs to be selectable by the user/installer. This can reduce nuisance tripping, increase robustness on arc fault detection and reduce product returns of arc fault breakers from customers. Allowing the firmware to load an LUT in memory based on the user selection/configuration during power up and then use this LUT for protection makes the firmware very flexible for updates in the future as new loads become prevalent in the residential or commercial marketplaces. Since LUTs are pre-allocated in fixed memory regions, it is feasible to update/replace/add or remove them, either remotely or on-site, to increase the flexibility of the arc fault breaker in the future.

## Claims

1. An arc fault circuit interrupter device (100) having:
a controller (110);
nonvolatile and volatile memories (142, 144);
an arc detection algorithm (25) and a plurality of Look Up Tables (27) including a default Look Up Table (27a) and a second Look Up Table (LUT);
the volatile memory (144) storing the default Look Up Table during arc detection calculations;
a Look Up Table identifier for indicating to a user the default Look Up Table; and
a Look Up Table selector mechanism for changing between the plurality of stored Look Up Tables to select a default Look Up Table for use with the detection algorithm;
the arc fault interrupter device being **characterized by**:
each Look Up Table storing pre-computed detection parameters for a different particular load configuration/profiles, the plurality of Look Up Tables (27) being stored separately from the arc detection algorithm (25) in the non-volatile memory (142).

2. The device of claim 1, wherein the Look Up Tables are pre-allocated into fixed memory regions of the nonvolatile memory.

3. The device of claim 1, wherein each Look Up Table is dedicated to a particular household room load and is designated by a common household room location.

4. The device of claim 1, wherein the identifier is one of a visible lighting sequence or a specific trip delay after a certain number of Push To Test button (134) presses.

5. The device of claim 1 or 2, wherein the device is a CAFI circuit breaker and the Look Up Table selector mechanism utilizes at least one of a Push To Test switch (134) and an On/Off switch (132) of the CAFI circuit breaker.

6. An arc fault detection method in a circuit interrupter device (100) as defined in any preceding claims including the steps of:
- storing in each Look Up Table, on a non-volatile memory (142), detection parameters for different load profiles;
- during arc detection calculation, storing the default Look Up Table, on the volatile memory (144);
- associating, to the default Look Up Table, a Look Up Table identifier for indicating to a user the default Look Up Table; and
- responsive to a user selection, through the Look Up Table selector mechanism, changing between the plurality of stored Look Up Tables to select a default Look Up Table for use with the detection algorithm.

7. A Computer Program Product including computer program code means which, when run on a computer, implement the method of claim 6.

8. The device of any one of claims 1 through 5, wherein the Look Up Table selector mechanism comprises a Push to Test switch, wherein operation of the Push to Test switch causes a fault indication status to be checked and if there is no fault indication, then causes changing between the plurality of stored Look Up Tables to select a default Look Up Table for use with the arc detection algorithm if a count of the Push to Test switch equals a Look Up Table switch count.

9. The device of any one of claims 1 through 5, wherein the Look Up Table selector mechanism comprises a Push to Test switch (PTT) or On-Off switch, wherein the controller (110) selects a pre-set default Look Up Table from the plurality of Look Up Tables for use with the arc detection algorithm according to a certain number and/or combination of PTT/On-Off switch presses/selections.

10. The method of claim 6 or 7, wherein the Look Up Table selector mechanism comprises a Push to Test switch, wherein operation of the Push to Test switch causes a fault indication status to be checked and if there is no fault indication, then causes changing between the plurality of stored Look Up Tables to select a default Look Up Table for use with the arc detection algorithm if a count of the Push to Test switch equals a Look Up Table switch count.

11. The method of claim 6 or 7, wherein the Look Up Table selector mechanism comprises a Push to Test switch (PTT) or On-Off switch, wherein a pre-set default Look Up Table is selected from the plurality of Look Up Tables for use with the arc detection algorithm according to a certain number and/or combination of PTT/On-Off switch presses/selections.

## Patentansprüche

1. Eine Fehlerlichtbogen-Schutzschaltervorrichtung (100), die Folgendes aufweist:
eine Steuereinrichtung (110);
einen nicht flüchtigen und einen flüchtigen Speicher (142, 144);
einen Lichtbogenerkennungsalgorithmus (25) und eine Vielzahl von Nachschlagetabellen (27), die eine Standard-Nachschlagetabelle (27a) und eine zweite Nachschlagetabelle (LUT) umfasst;
wobei der flüchtige Speicher (144) die Standard-Nachschlagetabelle während Lichtbogenerkennungsberechnungen speichert;
eine Nachschlagetabellen-Kennung, um einem Benutzer die Standard-Nachschlagetabelle anzuzeigen; und
einen Nachschlagetabellen-Auswahlmechanismus zum Wechseln zwischen der Vielzahl von gespeicherten Nachschlagetabellen, um eine Standard-Nachschlagetabelle zur Verwendung mit dem Erkennungsalgorithmus auszuwählen;
wobei die Fehlerlichtbogen-Schutzvorrichtung durch Folgendes gekennzeichnet ist:
Speichern, durch jede Nachschlagetabelle, vorberechneter Erkennungsparameter für eine unterschiedliche spezielle Lastkonfiguration/unterschiedliche spezielle Lastprofile, wobei die Vielzahl von Nachschlagetabellen (27) getrennt von dem Lichtbogenerkennungsalgorithmus (25) in dem nicht flüchtigen Speicher (142) gespeichert ist.

2. Vorrichtung gemäß Anspruch 1, wobei die Nachschlagetabellen in feste Speicherbereiche des nicht flüchtigen Speichers vorverteilt sind.

3. Vorrichtung gemäß Anspruch 1, wobei jede Nachschlagetabelle einer bestimmten Haushaltsraumlast zugewiesen ist und durch einen gemeinsamen Haushaltsraumstandort bezeichnet wird.

4. Vorrichtung gemäß Anspruch 1, wobei die Kennung eines von einer sichtbaren Beleuchtungssequenz oder einer spezifischen Auslöseverzögerung nach einer bestimmten Anzahl von Bedienungen einer Push-to-Test-Taste (134) ist.

5. Vorrichtung gemäß Anspruch 1 oder 2, wobei es sich bei der Vorrichtung um einen CAFI-Schutzschalter handelt und der Nachschlagetabellen-Auswahlmechanismus mindestens eines von einem Push-to-Test-Schalter (134) und einem Ein/Aus-Schalter (132) des CAFI-Schutzschalters verwendet.

6. Ein Verfahren zum Erkennen von Fehlerlichtbogen in einer Schutzschaltervorrichtung (100), wie in einem der vorhergehenden Ansprüche definiert, umfassend die folgenden Schritte:
- Speichern, in jeder Nachschlagetabelle, in einem nicht flüchtigen Speicher (142), von Erkennungsparametern für unterschiedliche Lastprofile;
- während der Berechnung der Lichtbogenerkennung, Speichern der Standard-Nachschlagetabelle in dem flüchtigen Speicher (144);
- Assoziieren, mit der Standard-Nachschlagetabelle, einer Nachschlagetabellen-Kennung, um einem Benutzer die Standard-Nachschlagetabelle anzuzeigen; und
- als Reaktion auf eine Benutzerauswahl, durch den Nachschlagetabellen-Auswahlmechanismus, Wechseln zwischen der Vielzahl von gespeicherten Nachschlagetabellen, um eine Standard-Nachschlagetabelle zur Verwendung mit dem Erkennungsalgorithmus auszuwählen.

7. Ein Computerprogrammprodukt, das Computerprogrammcodemittel umfasst, die, wenn sie auf einem Computer laufen, das Verfahren gemäß Anspruch 6 implementieren.

8. Vorrichtung gemäß einem der Ansprüche 1 bis 5, wobei der Nachschlagetabellen-Auswahlmechanismus einen Push-to-Test-Schalter beinhaltet, wobei die Betätigung des Push-to-Test-Schalters bewirkt, dass ein Fehleranzeigestatus überprüft wird, und wenn es keine Fehleranzeige gibt, dann bewirkt, dass zwischen der Vielzahl von gespeicherten Nachschlagetabellen gewechselt wird, um eine Standard-Nachschlagetabelle zur Verwendung mit dem Lichtbogenerkennungsalgorithmus auszuwählen, wenn ein Zählerstand des Push-to-Test-Schalters gleich einem Schalterzählerstand der Nachschlagetabelle ist.

9. Vorrichtung gemäß einem der Ansprüche 1 bis 5, wobei der Nachschlagetabellen-Auswahlmechanismus einen Push-to-Test-Schalter (PTT) oder einen Ein-Aus-Schalter beinhaltet, wobei die Steuereinrichtung (110) eine voreingestellte Standard-Nachschlagetabelle aus der Vielzahl von Nachschlagetabellen zur Verwendung mit dem Lichtbogenerkennungsalgorithmus gemäß einer bestimmten Anzahl und/oder Kombination von PTT/Ein-Aus-Schalterbedienungen/-auswahlen auswählt.

10. Verfahren gemäß Anspruch 6 oder 7, wobei der Nachschlagetabellen-Auswahlmechanismus einen Push-to-Test-Schalter beinhaltet, wobei die Betätigung des Push-to-Test-Schalters bewirkt, dass ein Fehleranzeigestatus überprüft wird, und wenn es keine Fehleranzeige gibt, dann bewirkt, dass zwischen der Vielzahl von gespeicherten Nachschlagetabellen gewechselt wird, um eine Standard-Nachschlagetabelle zur Verwendung mit dem Lichtbogenerkennungsalgorithmus auszuwählen, wenn ein Zählerstand des Push-to-Test-Schalters gleich einem Schalterzählerstand der Nachschlagetabelle ist.

11. Verfahren gemäß Anspruch 6 oder 7, wobei der Nachschlagetabellen-Auswahlmechanismus einen Push-to-Test-Schalter (PTT) oder einen Ein-Aus-Schalter beinhaltet, wobei eine voreingestellte Standard-Nachschlagetabelle aus der Vielzahl von Nachschlagetabellen zur Verwendung mit dem Lichtbogenerkennungsalgorithmus gemäß einer bestimmten Anzahl und/oder Kombination von PTT/Ein-Aus-Schalterbedienungen/-auswahlen auswählt wird.

## Revendications

1. Un dispositif interrupteur de circuit (100) de défaut d'arc ayant :
un contrôleur (110) ;
des mémoires non volatile et volatile (142, 144) ;
un algorithme (25) de détection d'arc et une pluralité de tables de recherche (27) incluant une table de recherche par défaut (27a) et une deuxième table de recherche (*Look Up Table*) (LUT) ;
la mémoire volatile (144) stockant la table de recherche par défaut pendant des calculs de détection d'arc ;
un identifiant de table de recherche pour indiquer à un utilisateur la table de recherche par défaut ; et
un mécanisme sélecteur de table de recherche pour permuter entre la pluralité de tables de recherche stockées afin de sélectionner une table de recherche par défaut pour son utilisation avec l'algorithme de détection ;
le dispositif interrupteur de défaut d'arc étant **caractérisé par le fait que** :
chaque table de recherche stocke des paramètres de détection pré-calculés pour une configuration de charge particulière différente/des profils différents, la pluralité de tables de recherche (27) étant stockée séparément de l'algorithme (25) de détection d'arc dans la mémoire non volatile (142).

2. Le dispositif de la revendication 1, dans lequel les tables de recherche sont pré-allouées dans des zones de mémoire fixe de la mémoire non volatile.

3. Le dispositif de la revendication 1, dans lequel chaque table de recherche est dédiée à une charge de pièce d'habitation particulière et est désignée par un emplacement de pièce d'habitation commun.

4. Le dispositif de la revendication 1, dans lequel l'identifiant est un élément parmi une séquence d'éclairage visible ou un délai de déclenchement spécifique après un certain nombre de pressions sur un bouton test (*Push To Test*) (134).

5. Le dispositif de la revendication 1 ou de la revendication 2, dans lequel le dispositif est un coupe-circuit CAFI et le mécanisme sélecteur de table de recherche utilise au moins un élément parmi un commutateur test (*Push to Test*) (134) et un commutateur de mise sous tension/hors tension (*On*/*Off*) (132) du coupe-circuit CAFI.

6. Un procédé de détection de défaut d'arc dans un dispositif interrupteur de circuit (100) tel que défini dans n'importe lesquelles des revendications précédentes incluant les étapes consistant à :
- stocker dans chaque table de recherche, sur une mémoire non volatile (142), des paramètres de détection pour des profils de charge différents ;
- pendant un calcul de détection d'arc, stocker la table de recherche par défaut, sur la mémoire volatile (144) ;
- associer, à la table de recherche par défaut, un identifiant de table de recherche pour indiquer à un utilisateur la table de recherche par défaut ; et
- en réponse à une sélection par un utilisateur, par l'intermédiaire du mécanisme sélecteur de table de recherche, permuter entre la pluralité de tables de recherche stockées afin de sélectionner une table de recherche par défaut pour son utilisation avec l'algorithme de détection.

7. Un produit-programme informatique incluant un moyen formant code de programme informatique qui, lorsqu'il est exécuté sur un ordinateur, met en oeuvre le procédé de la revendication 6.

8. Le dispositif de n'importe laquelle des revendications 1 à 5, dans lequel le mécanisme sélecteur de table de recherche comprend un commutateur test, l'actionnement du commutateur test amenant un statut d'indication de défaut à être vérifié et s'il n'y a pas d'indication de défaut, amenant alors une permutation entre la pluralité de tables de recherche stockées afin de sélectionner une table de recherche par défaut pour son utilisation avec l'algorithme de détection d'arc si un décompte du commutateur test est égal à un décompte du commutateur de table de recherche.

9. Le dispositif de n'importe laquelle des revendications 1 à 5, dans lequel le mécanisme sélecteur de table de recherche comprend un commutateur test (*Push to Test*) (PTT) ou un commutateur de mise sous tension/hors tension (*On-Off*), dans lequel le contrôleur (110) sélectionne une table de recherche par défaut préréglée parmi la pluralité de tables de recherche pour son utilisation avec l'algorithme de détection d'arc selon un certain nombre et/ou une combinaison de pressions/sélections de commutateurs PTT/On-Off.

10. Le procédé de la revendication 6 ou de la revendication 7, dans lequel le mécanisme sélecteur de table de recherche comprend un commutateur test, l'actionnement du commutateur test amenant un statut d'indication de défaut à être vérifié et s'il n'y a pas d'indication de défaut, amenant alors une permutation entre la pluralité de tables de recherche stockées pour sélectionner une table de recherche par défaut pour son utilisation avec l'algorithme de détection de défaut si un décompte du commutateur test est égal à un décompte du commutateur de table de recherche.

11. Le procédé de la revendication 6 ou de la revendication 7, dans lequel le mécanisme sélecteur de table de recherche comprend un commutateur test (*Push to Test*) (PTT) ou un commutateur de mise sous tension/hors tension (*On-Off*), dans lequel une table de recherche par défaut préréglée est sélectionnée parmi la pluralité de tables de recherche pour son utilisation avec l'algorithme de détection d'arc selon un certain nombre et/ou une combinaison de pressions/sélections de commutateur PTT/On-Off.
